# EUROPÄISCHE PATENTSCHRIFT

(11) **EP 4 016 648 B1**
(45) Veröffentlichungstag und Bekanntmachung des Hinweises auf die Patenterteilung: **26.03.2025**
(21) Anmeldenummer: 22153636.0
(22) Anmeldetag: 07.04.2017
(51) Int. Cl.: H10F 77/20, C23C 14/00, C23C 14/50, C23C 16/458, H01L 21/673, H10F 10/166, H10F 77/30

(54) **SOLARZELLE**
SOLAR CELL
CELLULE PHOTOVOLTAÏQUE

(30) Priorität: 11.04.2016 DE 102016106563
(43) Veröffentlichungstag der Anmeldung: 22.06.2022
(62) Teilanmeldung aus: 17717243.4
(73) Patentinhaber: Meyer Burger (Germany) GmbH, 09337 Hohenstein-Ernstthal (DE)
(72) Erfinder: Citarella, Giuseppe, 09112 Chemnitz (DE); Sperlich, Hans-Peter, 01309 Dresden (DE); Köhler, Gunnar, 09427 Ehrenfriedersdorf (DE); Wünsch, Frank, 10787 Berlin (DE); Sontag, Detlef, 08396 Waldenburg (DE); Mehlich, Mirko, 09127 Chemnitz (DE); König, Marcel, 09130 Chemnitz (DE); Papet, Pierre, 2068 Hauterive (CH)
(74) Vertreter: Steiniger, Carmen

(56) Entgegenhaltungen:
- EP-A1- 2 662 900
- WO-A1-2014/192739
- WO-A1-2015/064634
- FR-A1- 3 011 982
- US-A1- 2016 181 466
- US-A1- 2016 247 960
- US-A1- 2016 308 079

## Beschreibung

Die vorliegende Erfindung betrifft eine Solarzelle, die mit einem Verfahren zum Herstellen einer Solarzelle mit einem Heteroübergang, einer für einen Lichteinfall vorgesehenen Vorderseite und einer gegenüber der Vorderseite befindlichen Rückseite hergestellt ist, wobei das Verfahren die folgenden Schritte aufweist: Bereitstellen eines kristallinen Halbleitersubstrates eines ersten Leitungstyps; Ausbilden wenigstens einer ersten amorphen, nano- und/oder mikrokristallinen Halbleiterschicht oder -schichtfolge auf einer vorderseitigen Oberfläche des Halbleitersubstrates, entweder unter Ausbildung eines Vorderseitenemitters eines zweiten, zu dem ersten Leitungstyp entgegengesetzten Leitungstyps oder unter Ausbildung einer Vorderseitenoberflächenfeldlage des ersten Leitungstyps; Ausbilden wenigstens einer zweiten amorphen, nano- und/oder mikrokristallinen Halbleiterschicht oder -schichtfolge auf einer rückseitigen Oberfläche des Halbleitersubstrates, entweder unter Ausbildung einer Rückseitenoberflächenfeldlage des ersten Leitungstyps oder unter Ausbildung eines Rückseitenemitters des zweiten Leitungstyps; Ausbilden wenigstens einer elektrisch leitfähigen, transparenten Vorderseitenelektrodenschicht auf dem Vorderseitenemitter oder der Vorderseitenoberflächenfeldlage und Ausbilden wenigstens einer elektrisch leitfähigen, transparenten Rückseitenelektrodenschicht auf der Rückseitenoberflächenfeldlage oder dem Rückseitenemitter; Ausbilden einer vorderseitigen metallischen Kontaktschichtgitterstruktur zur elektrischen Kontaktierung des Vorderseitenemitters oder der Vorderseitenoberflächenfeldlage; vorderseitige PECVD-Abscheidung einer elektrisch nicht leitfähigen, transparenten dielektrischen Vorderseitendeckschicht nach Ausbilden der vorderseitigen Kontaktschichtgitterstruktur; und Ausbilden einer Rückseitenmetallisierung auf der Rückseitenelektrodenschicht.

Um eine Kontaktschichtgitterstruktur, wie beispielsweise eine Silberfingerstruktur als Sammelelektrode, auf einer transparenten dielektrischen Vorder- und/oder Rückseitendeckschicht, wie beispielsweise einer transparenten, leitfähigen Oxidschicht (TCO-Schicht), einer Solarzelle auszubilden, werden im Stand der Technik typischerweise die Silberfinger unter Verwendung einer Elektroplattierungstechnologie mit einer Maske aufgebracht, welche im Nachhinein wieder entfernt wird. Das Maskierungsmaterial als auch die mit dessen Aufbringung und Entfernung verbundenen Schritte sind kostenaufwändig und können zu unvorteilhaften Beeinflussungen der Solarzellencharakteristik führen.

Darüber hinaus besteht ein Problem von Solarzellen mit exponierter TCO-Beschichtung darin, dass sie unter Einwirkung von Feuchtigkeit, insbesondere bei erhöhter Temperatur, stark an Leistung verlieren können. Die unter Einwirkung von Feuchtigkeit auftretende (elektro)chemische Zersetzung bzw. Korrosion der TCO-Schicht führt zu einem Anstieg des Serienwiderstandes (R_{S}) und zu einer daraus folgenden Degradation des Füllfaktors (FF) der Solarzelle. Die Umwandlungseffizienz der Solarzelle (ETA) bricht stark ein. Insbesondere sogenannte bifaziale Solarzellen mit beidseitig offen liegendem TCO sind anfällig für solche Korrosionserscheinungen. Die Erfindung ist jedoch auch für Solarzellen mit monofazialer TCO-Beschichtung anwendbar.

Um die TCO-Oberfläche vor Korrosion zu schützen, kann auf das TCO eine Isolatorschicht, wie beispielsweise eine Siliziumoxid-, Siliziumnitrid- oder Siliziumoxinitridschicht aufgebracht werden. Diese muss jedoch dort, wo die TCO-Schicht elektrisch durch die Kontaktschichtgitterstruktur bzw. die Kontaktfinger kontaktiert werden soll, wieder entfernt werden oder darf in diesen Bereichen gar nicht erst abgeschieden werden. Hierfür wird typischerweise eine Maskierungstechnologie eingesetzt bzw. die über der Metallisierung abgeschiedene dielektrische Schicht durch Laserablation oder maskierte Ätzung lokal geöffnet, um Metallstrukturen aufzudrucken oder durch Plating zu erzeugen. Dies hat jedoch den Nachteil, dass durch das Öffnen der hermetischen dielektrischen Schicht potenzielle Leckpfade für ein späteres Eindringen von Feuchte geschaffen werden.

Um eine Isolatorbeschichtung auf dem TCO auszubilden und dennoch das TCO auf technologisch einfache Weise geeignet elektrisch kontaktieren zu können, wird in der Druckschrift EP 2 662 900 A1 vorgeschlagen, auf die Maskierung zu verzichten und die Kontaktschichtgitterstruktur aus einer ersten elektrisch leitfähigen Schicht aus einem Material mit einem niedrigen Schmelzpunkt und einer zweiten elektrisch leitfähigen Schicht auszubilden. Hierfür wird auf eine transparente dielektrische Vorderseitendeckschicht (TCO-Schicht) die erste elektrisch leitfähige Schicht mit dem Material mit dem niedrigen Schmelzpunkt aufgebracht, darauf ganzflächig eine Isolatorschicht abgeschieden, die erste elektrisch leitfähige Schicht durch Erhitzen aufgeschmolzen und dadurch die Isolatorschicht über der ersten leitfähigen Schicht aufgesprengt. Durch das Aufsprengen entstehen Cracks in der Isolatorschicht, in welche die daraufhin abgeschiedene zweite elektrisch leitfähige Schicht eindringen und einen elektrischen Kontakt zu der ersten elektrisch leitfähigen Schicht und damit zu der TCO-Schicht herstellen kann.

Bei dieser Technologie kommt man nicht umhin, die erste leitfähige Schicht nur an den späteren Kontaktstellen auszubilden und auch nur dort zu erhitzen. Man benötigt also auch hier mindestens eine strukturierte Abscheidung oder Strukturierung, steht zudem vor dem Problem, wie die lokale Erhitzung vorgenommen werden soll, und muss versuchen, die Temperaturbelastung der Solarzellen bei diesem Erhitzungsschritt so gering wie möglich zu halten, um die Solarzellencharakteristik nicht negativ zu beeinflussen. Aus der Druckschrift WO 2014/192739 A1 ist ein Verfahren zum Herstellen einer Solarzelle bekannt, bei dem während einer Abscheidung einer Isolierschicht eine bereits bestehende Kontaktstruktur mittels einer Metallmaske abgedeckt wird, sodass die Isolierschicht nicht auf der Kontaktstruktur abgeschieden wird.

Es ist daher die Aufgabe der vorliegenden Erfindung, eine Solarzelle zur Verfügung zu stellen, bei der auf wirklich einfache und effiziente Weise sowohl die Ausbildung eines geeigneten Feuchtigkeitsschutzes für die TCO-Schicht(en) der Solarzelle als auch eine einfache, hochqualitative und die Solarzelleneigenschaften nicht negativ beeinflussende elektrische Kontaktierung der Solarzelle gewährleistet ist. Die Erfindung ist in Anspruch 1 definiert.

Eine solche Solarzelle ist erfindungsgemäß durch ein Verfahren der oben genannten Gattung herstellbar, bei dem für die Abscheidung der Vorderseitendeckschicht eine oberflächenselektive PECVD-Abscheidung verwendet und die Vorderseitendeckschicht mit einer solchen Dicke abgeschieden wird, dass die Vorderseitendeckschicht direkt nach ihrer Schichtabscheidung, ohne zusätzliche Wärme- und/oder chemische Behandlung nur auf den die vorderseitige Kontaktschichtgitterstruktur umgebenden Bereichen, aber nicht auf der vorderseitigen Kontaktschichtgitterstruktur eine geschlossene Schicht ausbildet.

Überraschenderweise hat sich herausgestellt, dass sich die Vorderseitendeckschicht bei einer PECVD-Abscheidung zunächst nur auf der elektrisch leitfähigen, transparenten Vorderseitenelektrodenschicht und nicht bzw. nur minimal auf der Kontaktschichtgitterstruktur, also oberflächenselektiv, abscheidet. Damit kann die Vorderseitendeckschicht auch nach bereits erfolgter Ausbildung der Kontaktschichtgitterstruktur abgeschieden werden, ohne dass eine nachfolgende Abätzung der Vorderseitendeckschicht von der Kontaktschichtgitterstruktur erforderlich ist. Es kann also eine vollständige Metallisierung der Solarzelle vorgenommen werden und danach auf die gesamte Solarzelle die feuchtigkeitssperrende, elektrisch nicht leitfähige, transparente dielektrische Vorderseitendeckschicht abgeschieden werden, welche die Vorderseitenelektrodenschicht versiegelt.

Eine solche Oberflächenselektivität bei der Abscheidung ist bei anderen Schichtabscheideverfahren, wie der Atomlagenbeschichtung (ALD), dem Sputtern oder bei Bedampfungsverfahren, nicht erreichbar.

Dabei kommen bei der vorliegenden Erfindung als Vorderseitendeckschicht beispielsweise SiO/N-Schicht(en) in Betracht, die bei Solarzellen üblicherweise bereits als Antireflex- und Passivierschichten zum Einsatz kommen. Feuchteaffine AIOₓ-Schichten sind hingegen weniger als Vorderseitendeckschicht geeignet, können aber beispielsweise als obere Schichtlage einer aus einer Siliziumoxid- und einer Aluminiumoxid bestehenden Vorderseitendeckschicht vorteilhaft zur Feuchteaufnahme und damit als Barriereschicht vor Feuchtigkeit gegenüber der darunter liegenden Siliziumoxidschicht eingesetzt werden.

Das PECVD-Verfahren, das erfindungsgemäß zur Ausbildung der Vorderseitendeckschicht verwendet wird, hat zudem den Vorteil, dass es im Niedertemperaturbereich, also bei Temperaturen ≤ 200 °C, funktioniert, wodurch sich das erfindungsgemäße Verfahren insbesondere auch zur Anwendung bei temperaturempfindlichen Solarzellen, wie Heterojunction-Solarzellen mit amorphen, nano- und/oder mikrokristallinen Silizium-Oberflächenpassivierungsschichten eignet.

Eine solche Feuchtigkeitssperre kann gemäß einer Ausführungsform der vorliegenden Erfindung auch auf der Solarzellenrückseite vorgesehen werden. Dabei weist das Ausbilden der Rückseitenmetallisierung folgende Schritte auf: Ausbilden einer rückseitigen metallischen Kontaktschichtgitterstruktur zur elektrischen Kontaktierung des Rückseitenemitters oder der Rückseitenoberflächenfeldlage; rückseitige PECVD-Abscheidung einer elektrisch nicht leitfähigen, transparenten dielektrischen Rückseitendeckschicht nach Ausbilden der rückseitigen Kontaktschichtgitterstruktur; wobei für die Abscheidung der Rückseitendeckschicht eine oberflächenselektive PECVD-Abscheidung verwendet und die Rückseitendeckschicht mit einer solchen Dicke abgeschieden wird, dass die Rückseitendeckschicht direkt nach ihrer Schichtabscheidung, ohne zusätzliche Wärme- und/oder chemische Behandlung nur auf den die rückseitige Kontaktschichtgitterstruktur umgebenden Bereichen, aber nicht auf der rückseitigen Kontaktschichtgitterstruktur eine geschlossene Schicht ausbildet.

Somit ist das Verfahren zum Beispiel auch bei bifazialen Solarzellen, wie beispielsweise bifazialen Heterojunction-Rückseitenemittersolarzellen, anwendbar.

Die vorder- und oder die rückseitige Kontaktschichtgitterstruktur kann zunächst als eine Keimschichtstruktur ausgebildet werden, die nachfolgend verstärkt wird. Hierfür ist in einer Variante des Verfahrens vorgesehen, dass auf der vorderseitigen Kontaktschichtgitterstruktur wenigstens eine vorderseitige metallische Kontaktdickenverstärkungsschicht unter Nutzung des Materials der Vorderseitendeckschicht als galvanischer Maskierungsschicht ohne vorherige Strukturierung und/oder ohne zumindest teilweise Entfernung der Vorderseitendeckschicht galvanisch abgeschieden wird, und/oder auf der rückseitigen Kontaktschichtgitterstruktur wenigstens eine rückseitige metallische Kontaktdickenverstärkungsschicht unter Nutzung des Materials der Rückseitendeckschicht als galvanischer Maskierungsschicht ohne vorherige Strukturierung und/oder zumindest teilweise Entfernung der Rückseitendeckschicht galvanisch abgeschieden wird.

Dabei wird die vorder- und/oder die rückseitige Kontaktschichtgitterstruktur zunächst als Keimschicht- oder Seed-Struktur als eine sehr dünne Metallisierungsstruktur, beispielsweise in Form von Fingern oder Busbars, auf die Oberfläche der elektrisch leitfähigen, transparenten Vorder- und/oder Rückseitenelektrodenschicht aufgebracht, wie beispielsweise gedruckt und getempert. Als Material für die Seed-Struktur kann beispielsweise eine Paste, wie eine Silberpaste, verwendet werden.

Nach dem Aufbringen der Seed-Struktur wird die Vorder- und/oder die Rückseitendeckschicht mittels PECVD-Abscheidung auf die jeweilige Solarzellenseite(n) abgeschieden. Bei dieser PECVD-Abscheidung wird, wie oben ausgeführt, die Seed-Struktur nicht bzw. nicht vollflächig beschichtet. Dadurch kann die Seed-Struktur nach der Abscheidung der Vorder- und/oder die Rückseitendeckschicht, ohne diese auf der Seed-Struktur entfernen zu müssen, beispielsweise galvanisch nachverstärkt werden. Zur galvanischen Nachverstärkung kann beispielsweise das LIP(Light Induced Plating)-Verfahren verwendet werden. Als Material für die Kontaktdickenverstärkungsschicht kommt Silber, aber auch Kupfer in Betracht. Die vorzugsweise, aber nicht ausschließlich galvanisch erzeugbare, metallische Kontaktdickenverstärkungsschicht haftet bei dieser Ausführungsform des Verfahrens sehr gut auf der Seed-Struktur und erhöht deren elektrische Leitfähigkeit.

Diese Variante des Verfahrens hat den Vorteil, dass keine SiON-Schicht als galvanische Maske zusätzlich abgeschieden werden muss, da die die Seed-Struktur umgebende, auf der elektrisch leitfähigen, transparenten Vorder- und/oder Rückseitenelektrodenschicht liegende Vorder- und/oder Rückseitendeckschicht bereits die Maskenfunktion übernimmt.

Darüber hinaus kann mit dieser Verfahrensführung eine bessere Zelleffizienz erreicht werden. So ergibt sich hierdurch die Möglichkeit, die elektrisch leitfähige, transparente Vorder- und/oder Rückseitenelektrodenschicht, die beispielsweise eine ITO-Schicht ist, dünner zu machen bzw. einen großen Teil der Dicke der Vorder- und/oder Rückseitenelektrodenschicht durch die Vorder- und/oder die Rückseitendeckschicht, also eine Si-ON-Schicht, zu ersetzen. Dadurch wird die Antireflexschicht der Solarzelle transparenter. Die Optik der Solarzelle kann dadurch sowohl im UV-Bereich, in dem die Absorption durch eine dünnere TCO-Schicht verringert wird, als auch im Infrarotbereich deutlich verbessert werden. Außerdem spart man dann, wenn als Vorder- und/oder Rückseitenelektrodenschicht ITO (Indium-Zinn-Oxid) verwendet wird, Indium.

Zudem kann mit dieser Variante des Verfahrens zur Herstellung der Kontaktschichtgitterstruktur verwendete Silberpaste eingespart und trotzdem eine sehr gute elektrische Leitfähigkeit der Kontaktfinger der Kontaktschichtgitterstruktur erreicht werden. Dieses Verfahren eignet sich für Modulverschaltungen mit und ohne Busbars, ohne zusätzliche Effizienzverluste zu riskieren. Trotz der erfindungsgemäß verwendeten Überbeschichtung ist eine gute Kontaktier- und/oder Lötbarkeit der Kontaktschichtgitterstruktur gegeben.

Die Vorder- und die Rückseitendeckschicht der vorliegenden Erfindung besitzen demnach Multifunktionalität. Sie können als Entspiegelungs- bzw. Reflexionsschutz-schicht(en), als Korrosionsschutz- bzw. Versiegelungsschicht(en) und/oder als Maske(n) für eine galvanische Nachverstärkung von Kontaktseedstrukturen eingesetzt werden.

In zweckmäßigen Ausgestaltungen der vorliegenden Erfindung wird/werden die vorderseitige metallische Kontaktschichtgitterstruktur vor der Abscheidung der Vorderseitendeckschicht und/oder die rückseitige metallische Kontaktschichtgitterstruktur vor der Abscheidung der Rückseitendeckschicht durch Tempern verfestigt.

Besonders effektiv ist es, wenn die Ausbildung der Vorderseitendeckschicht und der Rückseitendeckschicht in einem Bearbeitungsprozess in derselben Beschichtungsvorrichtung unmittelbar nacheinander erfolgt.

Eine mikrowellengestützte PECVD-Abscheidung zur Herstellung der transparenten dielektrischen Vorderseitendeckschicht und/oder der transparenten dielektrischen Rückseitendeckschicht hat sich als besonders schonend erwiesen. Alternativ kann bei der vorliegenden Erfindung die PECVD-Abscheidung zur Herstellung der transparenten dielektrischen Vorderseitendeckschicht und/oder der transparenten dielektrischen Rückseitendeckschicht eine HF(Hochfrequenz)-PECVD, eine VHF(Ultrahochfrequenz)-PECVD oder eine PECVD unter Verwendung einer ETP(Expanding Thermal Plasma)-Quelle sein. Grundsätzlich kann jedoch auch anstelle einer PECVD zur Herstellung der transparenten dielektrischen Vorderseitendeckschicht und/oder der transparenten dielektrischen Rückseitendeckschicht eine Hotwire-CVD eingesetzt werden.

Vorzugsweise wird für die Abscheidung der Vorderseitendeckschicht und/oder der Rückseitendeckschicht wenigstens eine SiOₓ-, SiNₓ-, SiOₓN_{y}-, AlOₓ-, AlNₓ-, TiO₂-Schicht, wenigstens ein elektrisch leitfähiges Oxid oder eine aus einer Kombination aus wenigstens zwei der vorgenannten Materialien bestehende Schicht oder Schichtfolge verwendet.

Besonders bevorzugt wird für die Abscheidung der Vorderseitendeckschicht wenigstens eine SiOₓ-Schicht und/oder für die Abscheidung der Rückseitendeckschicht wenigstens eine SiNₓ-Schicht verwendet. So kann beispielsweise auf der Solarzellenvorderseite eine SiO₂-Schicht mit einer Dicke in einem Bereich von 70 und 100 nm als Vorderseitendeckschicht und/oder auf der Solarzellenrückseite ein SiNₓ-Schicht mit einer Dicke in einem Bereich von 80 und 120 nm als Rückseitendeckschicht aufgebracht werden.

In einer optionalen Ausbildung des Verfahrens wird/werden die Vorderseitendeckschicht und/oder die Rückseitendeckschicht bei der Abscheidung wenigstens teilweise mit Kohlenstoff dotiert. Beispielsweise kann eine Tetramethylsilan-Beimischung zur verwendeten Silanchemie erfolgen. Durch eine Dotierung mit Kohlenstoff kann beispielsweise die Nassätzrate bzw. eine chemische Angreifbarkeit der Vorderseitendeckschicht und/oder der Rückseitendeckschicht reduziert werden.

Vorzugsweise wird/werden bei dem Verfahren die Vorderseitendeckschicht und/oder die Rückseitendeckschicht bei möglichst geringen Temperaturen, also in einem Temperaturbereich zwischen 50 °C und 250 °C, besonders bevorzugt bei Temperaturen ≤ 200 °C, abgeschieden. Der kurzzeitige zusätzliche Temperatureintrag, beispielsweise von 150 °C bis 200 °C für 2 bis 3 min, während der PECVD verbessert die Leitfähigkeit der Kontaktfinger und deren Kontaktierung auf dem TCO. Hierdurch ergibt sich ein leichter Anstieg des Füllfaktors FF der Solarzelle, beispielsweise von + 0,5 %, und der Umwandlungseffizienz ETA der Solarzelle, beispielsweise von + 0,2 %.

Für die Ausbildung der vorderseitigen und/oder der rückseitigen Kontaktschichtgitterstruktur und der wenigstens einen vorderseitigen und/oder der wenigstens einen rückseitigen Kontaktdickenverstärkungsschicht kann/können vorteilhafterweise wenigstens ein elektrisch leitfähiges Oxid, wenigstens ein Metall, wenigstens eine metallische Legierung oder eine Kombination aus wenigstens zwei der vorgenannten Materialien verwendet werden.

Für die Ausbildung der vorderseitigen und/oder der rückseitigen Kontaktschichtgitterstruktur und der wenigstens einen vorderseitigen und/oder der wenigstens einen rückseitigen Kontaktdickenverstärkungsschicht wird bei dem Verfahren vorzugsweise ein Material ausgewählt, das überwiegend, das heißt zu mehr als 50 %, aus Silber oder aus Kupfer besteht.

Besonders zweckmäßig ist es, wenn die vorderseitige und/oder die rückseitige Kontaktschichtgitterstruktur als Fingerstruktur unter Verwendung einer Paste gedruckt wird/werden.

Bevorzugt wird bei dem Verfahren für die Ausbildung der Vorderseitenelektrodenschicht und/oder der Rückseitenelektrodenschicht transparentes, elektrisch leitfähiges Oxid, also eine TCO-Schicht, wie beispielsweise eine ITO-Schicht, verwendet.

Um einen besonders effektiven Zellschutz vor Korrosion zu erreichen, empfiehlt es sich, wenn die Ausbildung der Vorderseitendeckschicht vollständig über die gesamte Vorderseite, einschließlich der Bedeckung der Ränder des Halbleitersubstrates, und/oder die Ausbildung der Rückseitendeckschicht vollständig über die gesamte Rückseite, einschließlich der Bedeckung der Ränder des Halbleitersubstrates, vorgenommen wird. Die damit erreichbare beidseitige, vollständige, lückenlose hermetische Versiegelung der bereits metallisierten TCO-Oberflächen der Solarzelle einschließlich des Waferrandes verhindert einen Angriff von Feuchte am TCO wirksam sowohl auf Modulebene als auch auf Zellebene. Die Folge ist keine oder eine nur sehr geringe TCO-Degradation.

Eine solche, den Rand des Halbleitersubstrates einschließende Bedeckung kann nur dann erreicht werden, wenn ein geeigneter Substratträger verwendet wird. Daher wird ein Substratträger mit einem plattenförmigen Trägergitter vorgeschlagen, das wenigstens ein von einem Nestrahmen umgebenes hohles Trägernest zur Aufnahme jeweils eines flächigen Halbleitersubstrates aufweist, wobei von allen Seiten des Nestrahmens Haltehaken in das Trägernest auskragen, und an jedem Haltehaken wenigstens ein Haltestift vorgesehen ist, der parallel zu einer Oberfläche des aufzunehmenden Halbleitersubstrates ausgerichtet ist.

Vorzugsweise weist das Trägergitter wenigstens zwei benachbarte, durch einen Rahmenbalken des Nestrahmens getrennte Trägernester auf, und die Haltehaken sind an an dem Rahmenbalken befestigten und beidseitig des Rahmenbalkens in jeweils eines der Trägernester ragenden Haltebügeln vorgesehen.

Bevorzugte Ausführungsformen der vorliegenden Erfindung, deren Verlauf bzw. Aufbau, Funktion und Vorteile werden im Folgenden anhand von Figuren näher erläutert, wobei
- die Figuren 1 bis 3: schematisch einen zur Herstellung einer erfindungsgemäßen Solarzelle verwendeten Verfahrensablauf zeigen;
- Figur 4: schematisch eine Draufsicht auf eine Ausführungsform eines Substratträgers zeigt; und
- Figur 5: schematisch einen Querschnitt eines Rahmenbalkens mit Haltebügel eines Substratträgers zeigt, wobei schematisch angedeutet zwei Halbleitersubstrate auf Haltestiften des Haltebügels aufliegen.

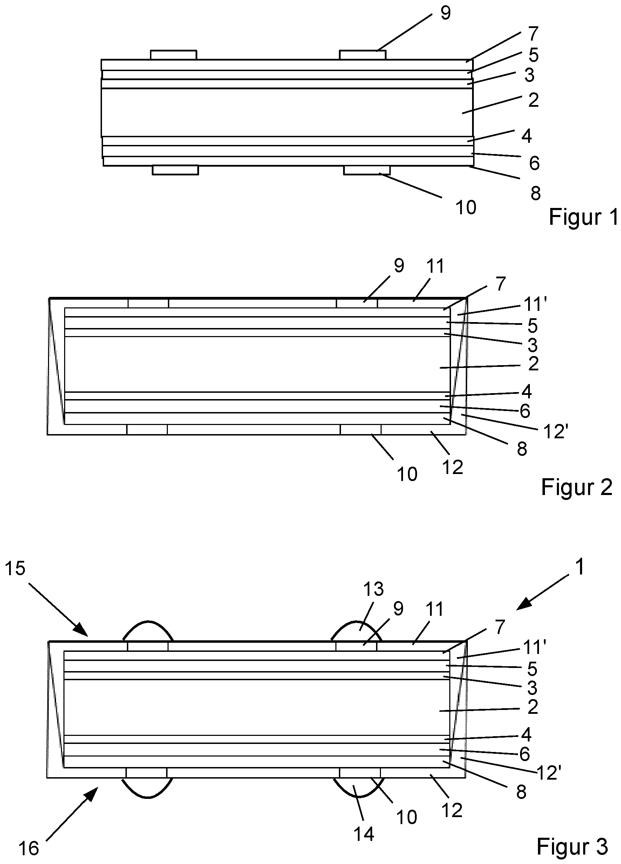

Wie es anhand von Figur 1 zu sehen ist, wird in dem Verfahren zunächst wenigstens ein Halbleitersubstrat 2 bereitgestellt. Das Halbleitersubstrat 2 ist von einem ersten Leitungstyp, kann also n- oder p-dotiert sein. Typischerweise, aber nicht unbedingt ist das Halbleitersubstrat 2 aus n-dotiertem Silizium ausgebildet.

Beidseitig des Halbleitersubstrates 2 sind auf diesem in der in Figur 1 gezeigten Ausführungsform intrinsische amorphe Halbleiterschichten 3, 4, in dem gezeigten Beispiel wenige Nanometer dünne i-a-Si-Schichten, vorgesehen. Anstelle der oder zusätzlich zu den intrinsischen amorphen Halbleiterschichten 3, 4 können in anderen Ausführungsformen der vorliegenden Erfindung auch intrinsische nano- und/oder mikrokristalline Halbleiterschichten, beispielsweise aus Silizium, zum Einsatz kommen.

Auf den intrinsischen amorphen Halbleiterschichten 3, 4 sind jeweils elektrisch leitfähige amorphe dotierte Halbleiterschichten 5, 6 vorgesehen. Anstelle der oder zusätzlich zu den amorphen dotierten Halbleiterschichten 5, 6 können in anderen Ausführungsformen der vorliegenden Erfindung auch nano- und/oder mikrokristalline dotierte Halbleiterschichten, beispielsweise aus Silizium, zum Einsatz kommen. In dem in Figur 1 gezeigten Ausführungsbeispiel ist auf der auf der Halbleitervorderseite befindlichen intrinsischen amorphen Siliziumschicht 3 eine p-dotierte amorphe Siliziumschicht 5, die also einen zu dem Halbleitersubstrat 2 entgegengesetzten Leitungstyp aufweist, unter Ausbildung eines Vorderseitenemitters vorgesehen. Ferner ist in dem in Figur 1 gezeigten Ausführungsbeispiel auf der auf der Halbleiterrückseite befindlichen intrinsischen amorphen Siliziumschicht 5 eine n-dotierte amorphe Siliziumschicht 6, die also den gleichen Leitungstyp wie das Halbleitersubstrat 2 aufweist, unter Ausbildung eines Rückseitenoberflächenfeldlage vorgesehen.

In anderen, nicht gezeigten Ausführungsformen der vorliegenden Erfindung kann auch auf der Vorderseite des Halbleitersubstrates 2 eine Vorderseitenoberflächenfeldlage und auf der Rückseite des Halbleitersubstrates 2 ein Rückseitenemitter vorgesehen sein.

In dem Beispiel von Figur 1 ist auf dem Vorderseitenemitter eine elektrisch leitfähige, transparenten Vorderseitenelektrodenschicht 7, welche in der gezeigten Ausführungsform eine TCO-Schicht, wie beispielsweise eine ITO-Schicht, ist, vorgesehen. Außerdem ist auf der Rückseitenoberflächenfeldlage ebenfalls eine elektrisch leitfähige, transparenten Rückseitenelektrodenschicht 8, welche in der gezeigten Ausführungsform eine TCO-Schicht, wie beispielsweise eine ITO-Schicht, ist, vorgesehen.

Zudem ist auf der Vorderseitenelektrodenschicht 7 eine vorderseitige metallische Kontaktschichtgitterstruktur 9 zur elektrischen Kontaktierung des Vorderseitenemitters und auf der Rückseitenelektrodenschicht 8 eine rückseitige metallische Kontaktschichtgitterstruktur 10 zur elektrischen Kontaktierung der Rückseitenoberflächenfeldlage vorgesehen. Die vorderseitige und die rückseitige metallische Kontaktschichtgitterstruktur 9, 10 sind in dem dargestellten Ausführungsbeispiel dünne, gedruckte, fingerförmige Silber-Seed-Strukturen.

Wie es in Figur 2 zu sehen ist, wird in einem nachfolgenden Verfahrensschritt ganzflächig auf die in Figur 1 gezeigte Struktur eine elektrisch nicht leitfähige, transparente dielektrische Vorderseitendeckschicht 11 mit einer PECVD-Abscheidung abgeschieden. Dabei lagert sich die Vorderseitendeckschicht 11 nur auf den die Kontaktschichtgitterstruktur 9 umgebenden Bereichen, also auf der Vorderseitenelektrodenschicht 7, nicht aber oder nur minimal auf der Kontaktschichtgitterstruktur 9 selbst ab.

Ferner wird auf der Rückseite der in Figur 1 gezeigten Struktur eine elektrisch nicht leitfähige, transparente dielektrische Rückseitendeckschicht 12 mit einer PECVD-Abscheidung abgeschieden. Dabei lagert sich die Rückseitendeckschicht 12 nur auf den die Kontaktschichtgitterstruktur 10 umgebenden Bereichen, also auf der Rückseitenelektrodenschicht 8, nicht aber oder nur minimal auf der Kontaktschichtgitterstruktur 10 selbst ab.

Das heißt, es erfolgt ein ungestörtes Schichtwachstum der Vorder- und der Rückseitendeckschicht 11, 12 auf dem TCO der Vorder- bzw. Rückseitenelektrodenschicht 7, 8, aber kein bzw. nur geringes Wachstum auf den Silberpastefingern der Kontaktschichtgitterstrukturen 9 bzw. 10. Man kann hier von einer selbstausrichtenden PECVD-Abscheidung sprechen.

Die Ausbildung der Vorderseitendeckschicht 11 erfolgt vollständig über die gesamte Vorderseite, einschließlich der Bedeckung 11' der Ränder des Halbleitersubstrates 2, und die Ausbildung der Rückseitendeckschicht 12 erfolgt vollständig über die gesamte Rückseite, einschließlich der Bedeckung 12' der Ränder des Halbleitersubstrates 2. Die Bedeckungen 11', 12' der Ränder des Halbleitersubstrates 2 verlaufen etwa keilförmig, ausgehend von der Vorderseite 15 bzw. der Rückseite 16 des Halbleitersubstrates 2 und können aneinander angrenzen oder einander überdecken.

Nach Abscheidung der Vorderseitendeckschicht 11 wird, wie in Figur 3 gezeigt, auf die vorderseitige Kontaktschichtgitterstruktur 9 galvanisch eine vorderseitige metallische Kontaktdickenverstärkungsschicht 13 unter Nutzung des Materials der Vorderseitendeckschicht 11 als galvanischer Maskierungsschicht ohne vorherige Strukturierung und/oder zumindest teilweise Entfernung der Vorderseitendeckschicht 11 abgeschieden. Außerdem wird nach Abscheidung der Rückseitendeckschicht 12, wie ebenfalls in Figur 3 zu sehen, auf die rückseitige Kontaktschichtgitterstruktur 10 galvanisch eine rückseitige metallische Kontaktdickenverstärkungsschicht 14 unter Nutzung des Materials der Rückseitendeckschicht 12 als galvanischer Maskierungsschicht ohne vorherige Strukturierung und/oder zumindest teilweise Entfernung der Rückseitendeckschicht 12 abgeschieden. Die Kontaktdickenverstärkungsschicht 13 bzw. 14 wächst typischerweise bei der Galvanik seitlich über die als Seed-Schicht verwendete Kontaktschichtgitterstruktur 9 bzw. 10 etwas hinaus.

Im Ergebnis entsteht die schematisch in Figur 3 im Querschnitt dargestellte Solarzelle 1 mit einer für einen Lichteinfall vorgesehenen Vorderseite 15 und einer gegenüber der Vorderseite 15 befindlichen Rückseite 16.

Die mit dem oben beschriebenen Verfahren hergestellte Solarzelle 1 lässt sich vor und nach der Beschichtung mit der Vorder- und der Rückseitendeckschicht 11, 12 gleich gut elektrisch kontaktieren. Die durch die Vorder- und die Rückseitendeckschicht 11, 12 ausgebildete Versiegelungsschicht bleibt vollständig intakt und muss nachträglich nicht lokal geöffnet werden, um einen elektrischen Kontakt zwischen der vorderseitigen Kontaktschichtgitterstruktur 9 und der zugehörigen Kontaktdickenverstärkungsschicht 13 sowie zwischen der rückseitigen Kontaktschichtgitterstruktur 10 und der zugehörigen Kontaktdickenverstärkungsschicht 14 herzustellen.

Zur Ausbildung der Vorder- und der Rückseitendeckschicht 11, 12 kommen bei der vorliegenden Erfindung vorzugsweise SiOₓ- und/oder SiNₓ-Schichten zum Einsatz, die optisch transparent sind und bei Wahl optimaler Schichtdicken die Entspiegelung der Solarzelle 1 sogar verbessern. So werden durch die Doppel-ARC-Funktion, wie zum Beispiel durch TCO und SiO₂, der Kurzschlussstrom I_{SC} und die Umwandlungseffizienz ETA der Solarzelle erhöht.

Grundsätzlich sind die Schritte zur Versiegelung von TCO-Schichten des erfindungsgemäßen Verfahrens auch bei Dünnfilmmodulen anwendbar.

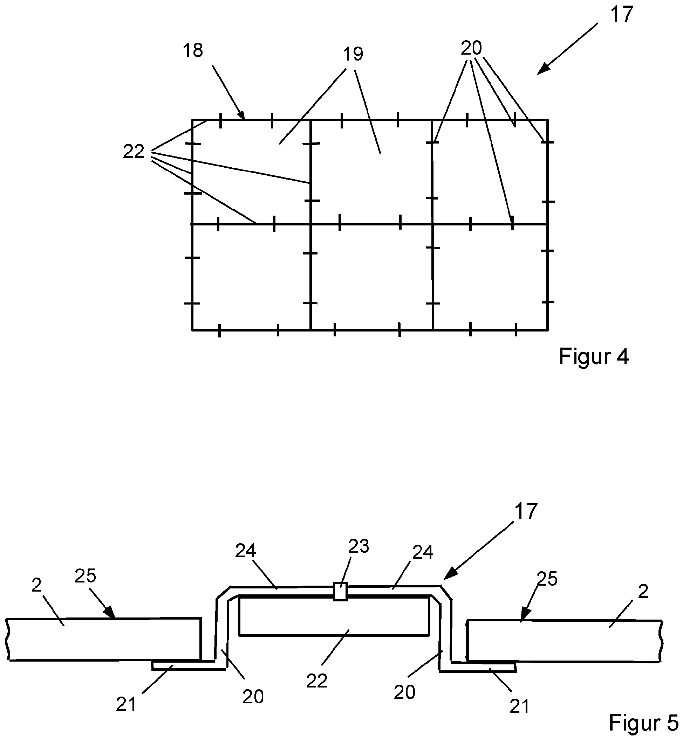

Figur 4 zeigt schematisch eine Draufsicht auf eine Ausführungsform eines Substratträgers 17. Der Substratträger 17 ist ein sogenannter Wafercarrier, der ein Trägergitter 18 mit mehreren in Reihen und Spalten angeordneten Trägernestern 19 aufweist. Jedes Trägernest 19 ist hierbei von einen Nestrahmen ausbildenden Rahmenbalken 22 umgeben. Die Trägernester 19 dienen jeweils der Aufnahme eines flächigen Halbleitersubstrates 2.

Von allen Seiten des Nestrahmens kragen an den Rahmenbalken 22 befestigte oder mit diesen einstückig verbundene Haltehaken 20 nach unten in das Trägernest 19 aus. Dabei ist, wie es in Figur 5 zu sehen ist, an jedem Haltehaken 20 ein Haltestift 21 vorgesehen ist, der parallel zu einer Oberfläche 25 des aufzunehmenden Halbleitersubstrates 2 ausgerichtet ist. Das Halbleitersubstrat 2 wird derart in das Trägernest 19 gelegt, dass es auf den von jedem der das Trägernest 19 umgebenden Rahmenbalken 22 ausgehenden Haltehaken 20 gehalten wird, wobei das Halbleitersubstrat 2 jeweils auf den Haltestiften 21 aufliegt.

Wie es in Figur 4 zu sehen ist, weist das Trägergitter 18 mehrere, einander benachbarte, jeweils durch einen Rahmenbalken 22 des Nestrahmens getrennte Trägernester 19 auf. Bei diesen Trägernestern 19 sind jeweils an den Rahmenbalken 22 Haltebügel 24 mit wenigstens einem Halteelement 23 derart befestigt, dass die an den Haltebügeln 24 befindlichen Haltehaken 20 mit den daran vorgesehene Haltestiften 21 in jeweils eines der Trägernester 19 ragen.

## Patentansprüche

1. Solarzelle (1) mit einem Heteroübergang, einer für einen Lichteinfall vorgesehenen Vorderseite (15) und einer gegenüber der Vorderseite (15) befindlichen Rückseite (16), aufweisend:
- ein kristallines Halbleitersubstrat (2) eines ersten Leitungstyps;
- wenigstens eine erste amorphe, nano- und/oder mikrokristalline Halbleiterschicht oder -schichtfolge (3, 5) auf einer vorderseitigen Oberfläche des Halbleitersubstrates (2), die entweder einen Vorderseitenemitter eines zweiten, zu dem ersten Leitungstyp entgegengesetzten Leitungstyps oder eine Vorderseitenoberflächenfeldlage des ersten Leitungstyps bildet;
- wenigstens eine zweite amorphe, nano- und/oder mikrokristalline Halbleiterschicht oder -schichtfolge (4, 6) auf einer rückseitigen Oberfläche des Halbleitersubstrates (2), die entweder eine Rückseitenoberflächenfeldlage des ersten Leitungstyps oder einen Rückseitenemitter des zweiten Leitungstyps bildet;
- wenigstens eine elektrisch leitfähige, transparente Vorderseitenelektrodenschicht (7) auf dem Vorderseitenemitter oder der Vorderseitenoberflächenfeldlage und wenigstens eine elektrisch leitfähige, transparente Rückseitenelektrodenschicht (8) auf der Rückseitenoberflächenfeldlage oder dem Rückseitenemitter;
- eine vorderseitige metallische Kontaktschichtgitterstruktur (9) zur elektrischen Kontaktierung des Vorderseitenemitters oder der Vorderseitenoberflächenfeldlage;
- eine vorderseitig mit PECVD-Abscheidung nach Ausbilden der vorderseitigen Kontaktschichtgitterstruktur (9) abgeschiedene, elektrisch nicht leitfähige, transparente dielektrische Vorderseitendeckschicht (11); und
- eine Rückseitenmetallisierung auf der Rückseitenelektrodenschicht (8);
**dadurch gekennzeichnet,**
**dass** für die Abscheidung der Vorderseitendeckschicht (11) eine oberflächenselektive PECVD-Abscheidung oder eine Hotwire-CVD verwendet und die Vorderseitendeckschicht (11) mit einer solchen Dicke abgeschieden ist, dass die Vorderseitendeckschicht (11) direkt nach ihrer Schichtabscheidung, ohne zusätzliche Wärme- und/oder chemische Behandlung nur auf den die vorderseitige Kontaktschichtgitterstruktur (9) umgebenden Bereichen, aber nicht auf der vorderseitigen Kontaktschichtgitterstruktur (9) eine geschlossene Schicht ausbildet, wobei
die elektrisch leitfähige, transparente Vorderseitenelektrodenschicht (7) eine TCO-Schicht ist;
für die Ausbildung der vorderseitigen Kontaktschichtgitterstruktur (9) ein Material ausgewählt ist, das überwiegend aus Silber oder aus Kupfer besteht und als Fingerstruktur unter Verwendung einer Paste gedruckt ist;
für die Abscheidung der Vorderseitendeckschicht (11) wenigstens eine SiOₓ-, SiNₓ-, SiOₓN_{y}-Schicht oder eine aus einer Kombination aus wenigstens zwei der vorgenannten Materialien bestehende Schicht oder Schichtfolge verwendet ist;
die Vorderseitendeckschicht (11) unter Verwendung einer Silanchemie abgeschieden ist; und
die Vorderseitendeckschicht (11) in einem Temperaturbereich zwischen 50 °C und 250 °C abgeschieden ist.

2. Solarzelle nach Anspruch 1, **dadurch gekennzeichnet, dass** die Vorderseitendeckschicht (11) vollständig über die gesamte Vorderseite, einschließlich einer Bedeckung (11') der Ränder des Halbleitersubstrates (2) ausgebildet ist.

3. Solarzelle nach Anspruch 1 oder 2, **dadurch gekennzeichnet, dass** eine Rückseitendeckschicht (12) vollständig über die gesamte Rückseite, einschließlich einer Bedeckung (12') der Ränder des Halbleitersubstrates (2) ausgebildet ist.

4. Solarzelle nach den Ansprüchen 2 und 3, **dadurch gekennzeichnet, dass** die Bedeckungen (11', 12') der Ränder des Halbleitersubstrates (2) ausgehend von der Vorderseite (15) bzw. der Rückseite (16) des Halbleitersubstrates (2) keilförmig verlaufen.

5. Solarzelle nach Anspruch 4, **dadurch gekennzeichnet, dass** die Bedeckungen (11', 12') der Ränder des Halbleitersubstrates (2) aneinander angrenzen oder einander überdecken.

6. Solarzelle nach einem der vorhergehenden Ansprüche, **dadurch gekennzeichnet, dass** die Vorderseitendeckschicht (11) und/oder die Rückseitendeckschicht (12) bei der Abscheidung wenigstens teilweise mit Kohlenstoff dotiert ist/sind.

## Claims

1. Solar cell (1) with a heterojunction, a front side (15) provided for an incident of light and a back side (16) located opposite the front side (15), comprising:
- a crystalline semiconductor substrate (2) of a first conductivity type;
- at least one amorphous, nano and/or microcrystalline semiconductor layer or layer sequence (3, 5) on a frontal surface of the semiconductor substrate (2), forming either a front side emitter of a second conductivity type opposite to the first conductivity type or a front side surface field layer of the first conductivity type;
- at least one second amorphous, nano and/or micro crystalline semiconductor layer or layer sequence (4, 6) on a rearward surface of the semiconductor substrate (2), forming either a back side surface field layer of the first conductivity type or a back side emitter of the second conductivity type;
- at least one electrically conductive, transparent front side electrode layer (7) on the front side emitter or the front side surface field layer and at least one electrically conductive, transparent back side electrode layer (8) on the back side surface field layer or the back side emitter;
- a frontal metallic contact layer grid structure (9) for electrically contacting the front side emitter or the front side surface field layer;
- an electrically non-conductive, transparent dielectric front side cover layer (11) deposited by PECVD deposition on its frontal face after forming the frontal contact layer grid structure (9); and
- a back side metallization on the back side electrode layer (8);
**characterized in that,**
a surface selective PECVD deposition or a Hotwire-CVD is used for the deposition of the front side cover layer (11) and the front side cover layer (11) is deposited with such a thickness that the front side cover layer (11) forms a closed layer directly after its layer deposition, without additional heat and/or chemical treatment, only on the areas surrounding the frontal contact layer grid structure (9), but not on the frontal contact layer grid structure (9), wherein
the electrically conductive, transparent front-side electrode layer (7) is a TCO layer; for the formation of the front side contact layer grid structure (9), a material is selected which consists predominantly of silver or copper and is printed as a finger structure using a paste;
for the deposition of the front side cover layer (11) at least one SiOₓ, SiNₓ, SiOₓN_{y} layer or a layer or layer sequence consisting of a combination of at least two of the aforementioned materials is used;
the front side cover layer (11) is deposited using a silane chemistry; and
the front side cover layer (11) is deposited in a temperature range between 50°C and 250°C.

2. Solar cell according to claim 1, **characterized in that** the front side covering layer (11) is formed completely over the entire front side, including a covering (11') of the edges of the semiconductor substrate (2).

3. Solar cell according to claim 1 or 2, **characterized in that** a back side covering layer (12) is formed completely over the entire back side, including a covering (12') of the edges of the semiconductor substrate (2).

4. Solar cell according to claims 2 and 3, **characterized in that** the coverings (11', 12') of the edges of the semiconductor substrate (2) extend in a wedge shape starting from the front side (15) or the back side (16) of the semiconductor substrate (2).

5. Solar cell according to claim 4, **characterized in that** the coverings (11', 12') of the edges of the semiconductor substrate (2) adjoin one another or cover one another.

6. Solar cell according to one of the preceding claims, **characterized in that** the front side cover layer (11) and/or the back side cover layer (12) is/are at least partially doped with carbon during deposition.

## Revendications

1. Cellule photovoltaïque (1) avec une hétérojonction, une face avant (15) destinée à l'incidence de la lumière et une face arrière (16) située à l'opposé de la face avant (15), comprenant:
- un substrat semi-conducteur cristallin (2) d'un premier type de conductivité ;
- au moins une première couche ou séquence de couches semi-conductrice amorphe, nano- et/ou microcristalline (3, 5) sur une surface avant du substrat semi-conducteur (2), qui forme ou bien un émetteur de face avant d'un deuxième type de conduction opposé au premier type de conduction ou bien une couche de champ de surface avant du premier type de conduction ;
- au moins une deuxième couche ou séquence de couches semi-conductrice amorphe, nano- et/ou microcristalline (4, 6) sur une surface arrière du substrat semi-conducteur (2), qui forme ou bien une couche de champ de surface arrière du premier type de conduction, ou bien un émetteur de face arrière du deuxième type de conduction ;
- au moins une couche d'électrode avant transparente et électroconductrice (7) sur l'émetteur de face avant ou la couche de champ de surface avant et au moins une couche d'électrode arrière transparente et électroconductrice (8) sur la couche de champ de surface arrière ou l'émetteur de face arrière ;
- une structure de grille de couche de contact métallique de face avant (9) pour entrer en contact électrique avec l'émetteur de face avant ou la couche de champ de surface avant ;
- une couche de couverture avant (11) diélectrique transparente et non électroconductrice déposé par dépôt PEVCD sur la face avant après formation de la structure de grille de couche de contact de face avant (9); et
- former une métallisation arrière sur la couche d'électrode arrière (8) ;
**caractérisé en ce que**
un dépôt PECVD sélectif de surface ou CVD par fil chaud est utilisé pour déposer la couche de couverture avant (11) et la couche de couverture avant (11) est déposée avec une épaisseur telle que la couche de couverture avant (11) immédiatement après son dépôt de couche forme une couche fermée uniquement sur les zones entourant la structure de grille de couche de contact de face avant (9), mais pas sur la structure de grille de couche de contact de face avant (9), sans un traitement thermique et/ou chimique supplémentaire,
la couche d'électrode avant transparente et électriquement conductrice (7) étant une couche de TCO ;
pour la formation de la structure de grille de couche de contact avant (9), on choisit un matériau constitué principalement d'argent ou de cuivre et imprimé sous forme de structure de doigt à l'aide d'une pâte ;
pour le dépôt de la couche de couverture avant (11), au moins une couche SiOₓ, SiNₓ, SiOₓN_{y} ou une couche ou une séquence de couches constituée d'une combinaison d'au moins deux des matériaux susmentionnés est utilisée ;
la couche de couverture avant (11) est déposée à l'aide d'une chimie au silane ; et la couche de couverture avant (11) est déposée dans une plage de température comprise entre 50°C et 250°C.

2. Cellule photovoltaïque selon la revendication 1, **caractérisée en ce que** la couche de couverture avant (11) est formée entièrement sur toute la surface avant, y compris un revêtement (11') des bords du substrat semi-conducteur (2).

3. Cellule photovoltaïque selon la revendication 1 ou 2, **caractérisée en ce que** une couche de couverture arrière (12) est formée entièrement sur toute la surface arrière, y compris un revêtement (12') des bords du substrat semi-conducteur (2).

4. Cellule photovoltaïque selon les revendications 2 et 3, **caractérisée en ce que** les revêtements (11', 12') des bords du substrat semi-conducteur (2) s'étendent en forme de coin à partir de la face avant (15) ou de la face arrière (16) du substrat semi-conducteur (2).

5. Cellule photovoltaïque selon la revendication 4, **caractérisée en ce que** les revêtements (11', 12') des bords du substrat semi-conducteur (2) se joignent ou se recouvrent.

6. Cellule photovoltaïque selon l'une des revendications précédentes, **caractérisée en ce que** la couche de couverture avant (11) et/ou la couche de couverture arrière (12) est/sont au moins partiellement dopée(s) avec du carbone lors du dépôt.
